# FASCICULE DE BREVET EUROPEEN

(11) **EP 2 926 544 B1**
(45) Date de publication et mention de la délivrance du brevet: **05.06.2019**
(21) Numéro de dépôt: 13788970.5
(22) Date de dépôt: 06.11.2013
(51) Int. Cl.: H04N 5/222, H04N 5/353, H01L 27/146, H04N 5/374, H04N 5/378

(54) **PROCEDE DE CAPTURE D'IMAGE AVEC UN TEMPS D'INTEGRATION TRES COURT**
BILDAUFNAHMEVERFAHREN MIT SEHR KURZER INTEGRATIONSZEIT
IMAGE-SENSING METHOD HAVING A VERY SHORT INTEGRATION TIME

(30) Priorité: 27.11.2012 FR 1261271
(43) Date de publication de la demande: 07.10.2015
(73) Titulaire: Teledyne e2v Semiconductors SAS, 38120 Saint-Egrève (FR)
(72) Inventeur: LIGOZAT, Thierry, F-38950 Quaix en Chartreuse (FR); DIASPARRA, Bruno, 38180 SEYSSINS (FR)
(74) Mandataire: Desvignes, Agnès
(86) Numéro de dépôt international: PCT/EP2013/073196
(87) Numéro de publication internationale: WO 2014/082827

(56) Documents cités:
- EP-A2- 1 708 496
- EP-A2- 1 742 369
- WO-A1-00/19705
- US-A1- 2010 026 823
- US-A1- 2011 134 290
- US-A1- 2012 188 404
- US-B2- 7 940 316

## Description

L'invention concerne les capteurs d'image, et plus particulièrement les capteurs matriciels à pixels actifs en technologie CMOS.

La technologie actuelle permet de réaliser des capteurs dans lesquels la durée d'intégration des charges électriques générées par la lumière dans les pixels peut varier entre quelques centaines de nanosecondes et vingt millisecondes (ou plus si on accepte de réduire la cadence des images à moins de 50 images par seconde). Il est difficile de descendre la durée d'intégration au-dessous de 100 ou 200 nanosecondes ; la raison en est que le séquencement du fonctionnement d'un capteur est établi par des circuits de logique synchrone ; on ne saurait pas descendre avec sécurité les durées de signaux synchrone au dessous d'une centaine de nanosecondes.

Le document US 7 940 316 B2 décrit un procédé permettant d'obtenir une image avec un temps d'intégration court en soustrayant une image caractérisée par un premier temps d'intégration d'une autre image caractérisée par un second temps d'intégration plus court que le premier. Toutefois, on pourrait avoir besoin de prendre des images avec une durée d'intégration encore plus faible. Cela peut être le cas par exemple si on souhaite se servir du capteur, en l'associant à une source de lumière puisée, pour mesurer des distances ou pour prendre une image d'une scène à une distance donnée. Cette mesure ou ce contrôle de la distance de la scène observée repose sur la connaissance du temps de parcours de la lumière entre la source et le capteur après réflexion sur un point de la scène observée. Elle repose donc au moins en partie sur une bonne synchronisation entre le moment où on envoie une impulsion de lumière et le moment où on intègre les charges générées par le retour de cette impulsion de lumière sur le capteur. La précision de la mesure ou du contrôle de la distance peut dépendre en particulier de la durée d'intégration des charges générées par l'impulsion de lumière. Typiquement, une durée de 100 nanosecondes correspond à une distance de 30 mètres parcourue par la lumière, mais on peut souhaiter bénéficier d'une durée d'intégration plus courte pour améliorer la précision de la mesure ou du contrôle de distance.

L'invention a donc pour but de proposer un procédé pour permettre de manière générale la production d'une image avec un temps d'intégration très court, et ceci avec un capteur de technologie ordinaire.

Selon l'invention, on propose un procédé pour réaliser une prise de vue d'une scène avec un temps d'intégration très court, en utilisant un capteur d'image comportant une matrice de pixels, chaque pixel comportant une photodiode et des moyens de lecture des charges accumulées par la photodiode pendant une durée d'intégration, la matrice comportant en outre des moyens de séquencement pour établir des instants de début et de fin de la durée d'intégration, le procédé étant caractérisé en ce que l'on produit deux images d'une même scène dans des conditions de lumière identiques, l'une des images correspondant à une intégration de charges pendant un premier intervalle de temps de durée Tᵢₙₜ et l'autre image correspondant à un deuxième intervalle de temps de durée T'ᵢₙₜ plus grande que Tᵢₙₜ, et on établit une différence entre ces deux images, représentant l'équivalent d'une image intégrée pendant un intervalle de temps T'ᵢₙₜ - Tᵢₙₜ.

Bien que les durées d'intégration Tᵢₙₜ ou T'ᵢₙₜ ne puissent pas descendre à des valeurs très basses, par exemple pas au-dessous de 100 nanosecondes, leur différence peut être très faible, par exemple de l'ordre de 1 à 10 nanosecondes et on produit donc par différence une image équivalente à celle qu'on obtiendrait avec un temps d'intégration très court.

La différence entre les deux images peut être une différence pixel à pixel entre les luminances fournies par un même pixel dans deux images complètes prises successivement dans les mêmes conditions. Il est nécessaire alors que la scène n'ait pas changé entre les deux images.

Alternativement, les deux images peuvent être des images partielles prises dans une même image complète ; les images partielles sont respectivement l'image des lignes impaires et l'image des lignes paires de la matrice ; la différence entre les images est la différence pixel à pixel entre les luminances des pixels correspondants d'une ligne impaire et les luminances des pixels d'une ligne paire immédiatement adjacente. On perd la moitié de la résolution verticale de l'image, mais on est sûr que la scène observée n'a pas changé entre les deux images.

Dans une mise en oeuvre de l'invention, la scène observée est illuminée par une impulsion lumineuse qui se substitue ou qui s'ajoute à un éclairage continu (naturel ou artificiel) de la scène.

Dans ce cas, le procédé utilise non seulement le capteur d'image mais aussi une source de lumière commandée qui fournit des impulsions lumineuses calibrées en durée et en intervalles de temps en synchronisme avec le fonctionnement du capteur. La lumière peut être une lumière visible ou en proche infrarouge, auquel sont sensibles les capteurs en silicium. On produit alors deux images d'une même scène observée, éclairée par une même impulsion de lumière ou par deux impulsions de lumière successives identiques, mais avec deux temps d'intégration légèrement différents.

Dans une application particulière, destinée à l'observation des points de la scène situés à une distance déterminée ou destinée au contrôle de distance d'une scène ou d'un point, on utilise des impulsions de lumière et on synchronise les durées d'intégration Tᵢₙₜ et T'ᵢₙₜ par rapport à l'impulsion de lumière (ou aux deux impulsions de lumière) d'une manière qu'on détaillera plus loin. Globalement, cette synchronisation consiste à faire en sorte que l'impulsion de lumière réfléchie par un point à une distance dᵢ déterminée chevauche (partiellement ou totalement) la portion de durée T'ᵢₙₜ qui se prolonge au-delà (ou en deçà) de la durée Tᵢₙₜ. La coïncidence plus ou moins complète entre l'impulsion réfléchie et cette portion de durée permet de déterminer si un point de la scène observée se situe ou non à la distance dᵢ, avec une précision d'autant plus grande que la durée de l'impulsion de lumière et la durée de la différence T'ᵢₙₜ - Tᵢₙₜ sont petites.

Dans le cas où il y a deux impulsions de lumière successives décalées dans le temps d'une durée de trame Tᵣ, l'une associée à une intégration pendant la durée Tᵢₙₜ et l'autre associée à une intégration pendant une durée T'ᵢₙₜ décalée dans le temps de la valeur Tᵣ, la coïncidence mentionnée ci-dessus est bien entendu une coïncidence après décalage de Tᵢₙₜ d'une durée Tᵣ puisque Tᵢₙₜ et T'ᵢₙₜ se situent dans des trames différentes.

D'autres caractéristiques et avantages de l'invention apparaîtront à la lecture de la description détaillée qui suit et qui est faite en référence aux dessins annexés dans lesquels :
- la figure 1 représente la constitution d'un pixel et de son circuit de lecture pour la mise en oeuvre de l'invention ;
- la figure 2 représente un chronogramme classique définissant la durée d'intégration de charges dans un pixel et la lecture de ces charges ;
- la figure 3 représente le principe de l'obtention de deux images successives pendant deux trames, avec des durées d'intégration différentes dans les deux trames ;
- la figure 4 représente un chronogramme d'obtention de deux images partielles avec deux durées d'intégration respectives différentes au cours d'une même trame ;
- la figure 5 représente la synchronisation entre des impulsions de lumière émises et les instants de début et fin d'intégration de charges pour l'observation de points situés à une distance dᵢ déterminée ;
- la figure 6 représente un signal de différence obtenu en fonction de la distance entre un point de la scène et le capteur autour d'une distance dᵢ déterminée ;
- la figure 7 représente un signal de différence lorsque la durée de l'impulsion lumineuse et la durée d'intégration (T'ᵢₙₜ - Tᵢₙₜ) ne sont pas égales ;
- la figure 8 représente un chronogramme de synchronisation entre les impulsions lumineuses et les instants d'intégration dans le cas où on fait la différence entre des images obtenues au cours de deux trames successives.

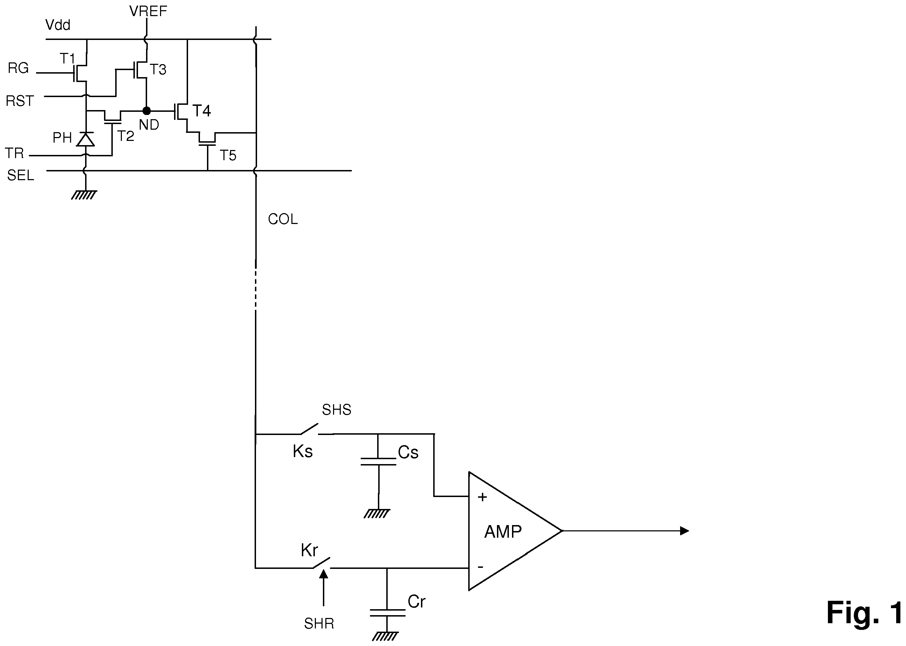

La figure 1 représente la constitution générale d'un pixel et de la partie de circuit de lecture extérieure à la matrice de pixels. Le procédé selon l'invention peut par exemple être mis en oeuvre avec un capteur d'image comportant une matrice de pixels de ce type, réalisée en technologie CMOS.

Le pixel comprend classiquement une photodiode PH et un noeud de stockage de charges ND dans lequel on peut stocker les charges engendrées par la photodiode pendant un temps d'intégration Tᵢₙₜ. Le pixel comporte par ailleurs plusieurs transistors MOS qui servent à le commander pour définir le temps d'intégration et extraire un signal représentant la quantité de charges stockées pendant ce temps d'intégration.

Plus précisément, le pixel comporte :
- un transistor T1 qui permet la réinitialisation du potentiel de la photodiode avant de commencer une nouvelle période d'intégration de durée Tᵢₙₜ ; ce transistor est commandé par un signal de réinitialisation global RG commun à tous les pixels de la matrice ; la fin du signal RG définit le début de la durée d'intégration Tᵢₙₜ.
- un transistor de transfert de charges T2 qui permet de vider dans le noeud de stockage ND les charges engendrées après une durée d'intégration Tᵢₙₜ ; ce transistor est commandé par un signal de transfert de charges TR qui peut être commun à toute une ligne de pixels de la matrice et même à plusieurs lignes ou toutes les lignes ; la fin de ce signal définit la fin de la durée d'intégration Tᵢₙₜ;
- un transistor de réinitialisation T3 qui permet de réinitialiser le potentiel du noeud de stockage après la lecture de la quantité de charges qui y a été stockée ; ce transistor est commandé par un signal de réinitialisation RST qui peut être commun à tous les pixels ;
- un transistor de lecture T4 qui est monté en suiveur de tension et qui permet de reporter de sa grille vers sa source le niveau de potentiel du noeud de stockage de charges ;
- et enfin un transistor de sélection T5 qui est relié à la source du transistor T4 et qui permet de reporter vers un conducteur de colonne COL (commun aux pixels d'une même colonne de la matrice) le potentiel du noeud de stockage de charges lorsqu'on veut lire la quantité de charges stockée dans le noeud de stockage de charges ; ce transistor est commandé par un signal de sélection de ligne SEL commun à tous les pixels d'une ligne ; les pixels sont lus ligne par ligne et il y a donc un signal de sélection SELᵢ respectif pour la ligne de rang i, ce signal ne chevauchant pas les signaux de sélection des autres lignes.

Le circuit de lecture, extérieur à la matrice de pixels et relié aux différents conducteurs de colonne, comprend pour chaque colonne un circuit d'échantillonnage. Le circuit d'échantillonnage échantillonne, par exemple dans deux capacités Cr et Cs, le potentiel du conducteur de colonne à l'aide d'interrupteurs Kr et Ks, respectivement à un instant où le noeud de stockage a été remis à zéro et à un instant où on veut déterminer la quantité de charges accumulée dans le noeud de stockage. La différence entre les potentiels échantillonnés dans les capacités représente la quantité de charges accumulée. Elle peut être lue par un amplificateur différentiel AMP, puis numérisée, ou directement numérisée, par exemple à l'aide d'un compteur, d'une rampe de tension linéaire, et d'un comparateur.

L'ensemble des signaux numériques recueillis pour tous les pixels de la matrice, lus successivement ligne par ligne, constitue une image de la scène. Cette image peut se décomposer en deux images partielles si on lit séparément les lignes paires et les lignes impaires.

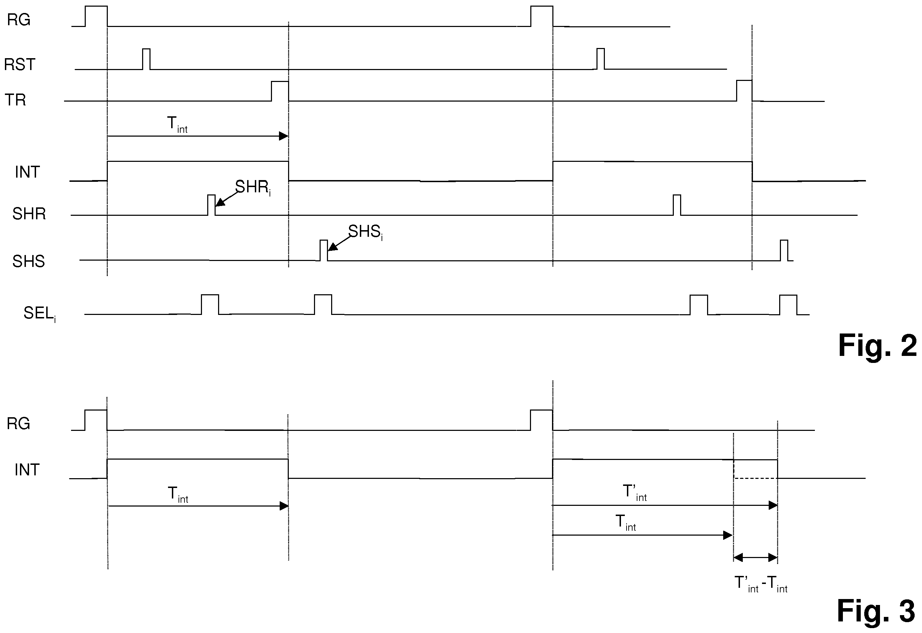

La figure 2 expose un chronogramme classique de fonctionnement, montrant comment on peut définir et régler la durée d'intégration du pixel ainsi décrit. On y voit :

### Signaux de commande du pixel :

- le signal de réinitialisation global RG dont la fin définit le début de la durée d'intégration Tᵢₙₜ pendant laquelle la photodiode du pixel peut intégrer des charges ; le signal RST maintient à une valeur fixe le potentiel de la photodiode tant qu'il est présent et il empêche l'intégration de charges ;
- le signal de réinitialisation RST, qui réinitialise à une valeur fixe le potentiel du noeud de stockage ND, en vue de lire ce potentiel avant de remplir le noeud de stockage avec des charges issues de la photodiode ;
- le signal de transfert TR par lequel les charges engendrées par la lumière dans la photodiode pendant la durée d'intégration sont transférées dans le noeud de stockage de charges ND.

Les signaux RG, RST et TR peuvent être communs à toutes les lignes de pixels de la matrice.

La ligne INT sur la figure 2 ne représente pas un signal de commande contrairement aux autres lignes mais elle représente la définition de la durée d'intégration Tᵢₙₜ dont on voit qu'elle commence à la fin du signal RST et qu'elle se termine à la fin du signal TR. On se référera dans la suite au créneau temporel INT pour simplifier, plutôt qu'aux signaux RG et TR qui le déterminent.

### Signaux de lecture :

- signal d'échantillonnage SHR ; il échantillonne dans la capacité Cr le niveau de potentiel de sortie du pixel, présent sur le conducteur de colonne COL après la réinitialisation du noeud de stockage par le signal RST et avant transfert de charges par le signal TR ; attention, seul le signal SHRᵢ correspondant à la lecture de la ligne de rang i est représenté, alors qu'en réalité une succession de signaux SHR est émise entre le signal RST et le signal TR, chaque signal SHR correspondant à une ligne respective ;
- signal d'échantillonnage SHS ; il échantillonne dans la capacité Cs le niveau de potentiel de sortie du pixel, présent sur le conducteur de colonne COL après la fin du signal de transfert de charges TR ; attention, seul le signal SHSᵢ correspondant à la lecture de la ligne de rang i est représenté alors qu'en réalité une succession de signaux SHS est émise après le signal TR ;
- signal SELᵢ sélectionnant les pixels de la ligne de rang i pour la lecture de ces pixels ; le signal SELᵢ est établi une première fois pendant l'émission du signal SHRᵢ correspondant à cette ligne puis une deuxième fois pendant l'émission du signal SHSᵢ correspondant à cette même ligne.

Les signaux SEL correspondant aux différentes lignes sont émis successivement sans chevauchement mutuel.

Selon l'invention, on propose de prendre deux images de la même scène, mais avec deux temps d'intégration Tᵢₙₜ et T'ᵢₙₜ très légèrement différents ; on fait ensuite la différence des images, cette différence représentant l'équivalent d'une intégration pendant une durée très courte T'ᵢₙₜ-Tᵢₙₜ. Cette différence est bien sûr plus courte que la durée Tᵢₙₜ puisqu'on cherche à obtenir un temps d'intégration équivalent plus court que ce que le capteur pourrait normalement établir. La durée Tᵢₙₜ est elle-même une durée aussi courte que possible par rapport aux possibilités de séquencement synchrone du capteur.

La figure 3 représente le chronogramme dans le cas où on prend deux images successives, la scène étant supposée inchangée entre les deux images.

Les signaux des deux images, représentant les luminances reçues par les pixels pendant des durées respectives Tᵢₙₜ et T'ᵢₙₜ, sont soustraits pixel à pixel et l'image différence qui en résulte est la même que celle qu'on aurait pu obtenir avec un temps d'intégration très court si on avait su le faire. Dans un exemple, le capteur est capable de produire un temps d'intégration de l'ordre de 100 nanosecondes mais pas plus court. Toutefois, il est capable de produire deux temps d'intégration différents respectivement de 100 nanosecondes et 110 nanosecondes. La différence des images correspond à un temps d'intégration de 10 nanosecondes que le capteur n'aurait pas pu produire directement.

Pour produire deux temps d'intégration différents ayant cette petite différence de 10 nanosecondes, on utilisera une logique asynchrone avec des portes logiques et des circuits logiques à retard. Le retard produit par un simple inverseur CMOS est de l'ordre de la nanoseconde. On sait donc produire, par des circuits logiques asynchrones utilisant de tels inverseurs, des signaux logiques de durées légèrement différentes Tᵢₙₜ et T'ᵢₙₜ même si la durée du signal ne peut pas descendre au-dessous d'une certaine limite.

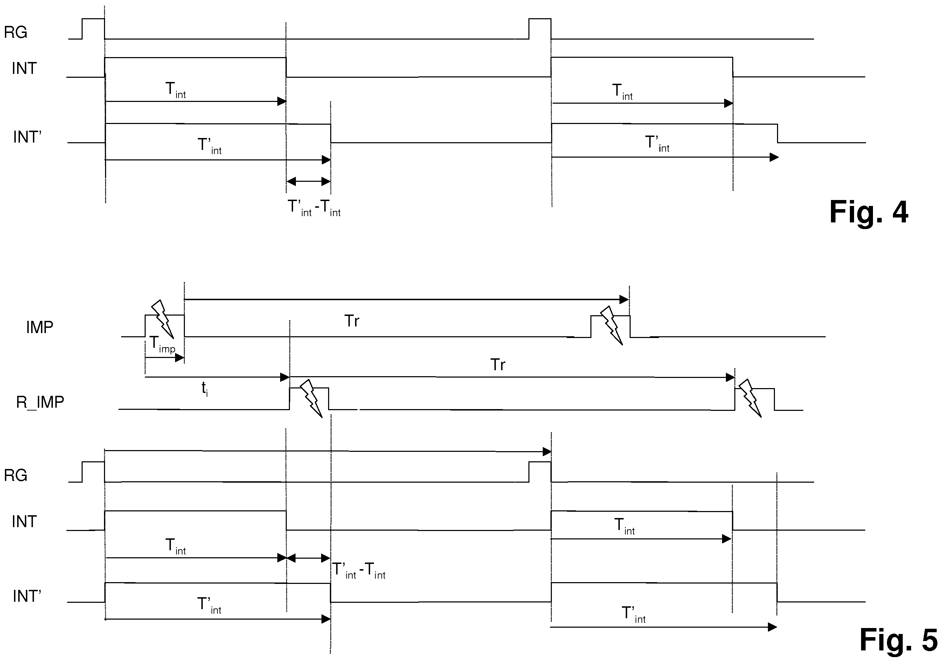

Sur la figure 4, on a représenté le chronogramme dans une variante de réalisation dans laquelle les deux images de la même scène, obtenues avec deux temps d'intégration différents, sont des images partielles semblables et prises au même moment. Une manière de les obtenir est de produire deux images entrelacées, la première image étant obtenue par l'ensemble des lignes impaires de la matrice, et la deuxième image étant obtenue par l'ensemble des lignes paires. On fait la différence pixel à pixel entre deux lignes adjacentes. On perd en résolution verticale puisque les images partielles contiennent deux fois moins de lignes, mais l'image différence est obtenue en une seule trame d'image et non en deux trames successives.

La ligne INT de la figure 4 représente le temps d'intégration pour les lignes impaires. La ligne INT' représente le temps d'intégration pour les lignes paires. Dans ce cas, un premier signal de transfert de charges des photodiodes vers les noeuds de stockage de charge est produit et appliqué uniquement aux pixels des lignes impaires, et un autre signal de transfert est produit et appliqué uniquement aux pixels des lignes paires, alors que dans le cas de la figure 3 le signal de transfert est appliqué à toute la matrice. Le signal de réinitialisation RST peut être appliqué en commun aux lignes paires et impaires ou séparément aux lignes paires et impaires.

Dans un mode de mise en oeuvre du procédé selon l'invention, l'éclairage de la scène est un éclairage impulsionnel. On observe la différence entre deux images de la même scène, obtenues par un éclairage impulsionnel identique. Dans un cas, la source de lumière impulsionnelle fournit une seule impulsion et on effectue la différence pixel à pixel entre les lignes paires et impaires comme indiqué ci-dessus ; dans un autre cas, la source de lumière fournit deux impulsions séparées par la durée d'une trame et on fait alors la différence pixel à pixel entre les deux images complètes obtenues au cours de deux trames successives.

Une application particulière de l'intégration pendant un temps très court par différence entre deux images, en présence d'un éclairement par des impulsions de lumière est l'obtention d'une image des points de la scène situés à une distance déterminée dᵢ du capteur et uniquement de ces points, avec une précision élevée sur cette distance.

Pour cela, on émet des impulsions de lumière très courtes par rapport à la durée d'intégration Tᵢₙₜ, de préférence des impulsions dont la durée est égale ou à peu près égale à la différence T'ᵢₙₜ - Tᵢₙₜ.

La figure 5 représente le chronogramme de fonctionnement dans le cas où on produit une différence de deux images partielles prises pendant une même trame avec une seule impulsion de lumière, dans l'intention d'observer les points de la scène situés à une distance dᵢ bien déterminée.

On émet une succession d'impulsions avec une période Tr qui est la période de trame du capteur. Pour chaque impulsion, donc pour chaque trame, on établit deux images partielles dont on va faire la différence : image des lignes paires et image des lignes impaires. L'impulsion lumineuse (ligne IMP de la figure 5) émise à un instant donné par la source est réfléchie (ligne R_IMP) par un point de la scène situé à une distance dᵢ (celle que l'on veut observer) et parvient au capteur avec un décalage temporel tᵢ qui dépend de la distance de ce point. En général, si la source et le capteur sont situés au même endroit, le temps tᵢ est égal à 2dᵢ/c, c étant la vitesse de la lumière. Le fonctionnement du capteur est synchronisé sur celui de la source de lumière qui émet les impulsions : le début de trame du capteur (déterminé par la fin du signal de réinitialisation RG) est émis à un instant précis par rapport à l'instant d'émission de l'impulsion lumineuse, en tenant compte des durées d'intégration Tᵢₙₜ et T'ᵢₙₜ, de telle sorte que la portion de durée T'ᵢₙₜ qui se prolonge au-delà de la durée Tᵢₙₜ corresponde au moment où arrive l'impulsion de retour R_IMP.

On synchronise donc le signal de réinitialisation RG, et les signaux de transfert TR, de telle manière que l'impulsion de lumière réfléchie R_IMP coïncide avec la portion de durée T'ᵢₙₜ qui ne coïncide pas avec la durée Tᵢₙₜ. Dans une situation idéale simplifiée, la durée Tᵢₘₚ de l'impulsion de lumière est à peu près égale à la durée T'ᵢₙₜ - Tᵢₙₜ et l'impulsion de lumière réfléchie R_IMP est exactement calée sur la portion de durée T'ᵢₙₜ - Tᵢₙₜ lorsque le point de réflexion est exactement à la distance dᵢ. Dans ce cas, on comprend que la première image intégrée pendant la durée Tᵢₙₜ ne fournit aucun signal lié à l'impulsion de lumière réfléchie puisque celle-ci arrive trop tard, après la durée d'intégration Tᵢₙₜ ; au contraire la deuxième image, intégrée pendant la durée plus longue T'ᵢₙₜ fournit un signal en réponse à l'impulsion de lumière réfléchie. La différence des images pour un pixel donné est donc liée directement à la présence d'un point à la distance dᵢ dans la scène observée.

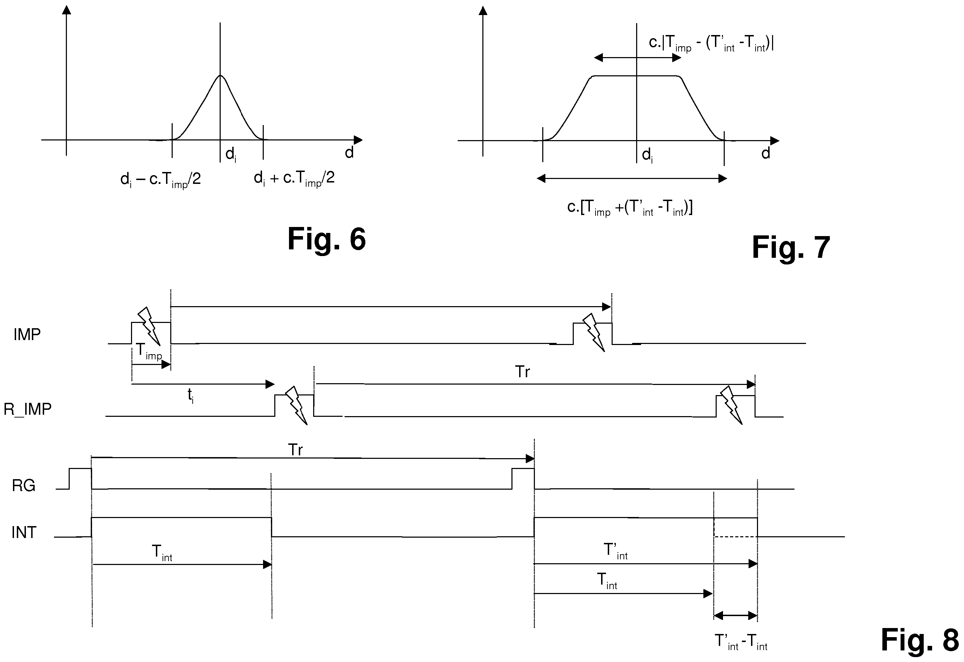

On peut tracer une courbe du signal résultant de cette différence en fonction de la distance réelle d entre le point de la scène et le capteur autour de la valeur théorique dᵢ pour laquelle la synchronisation est exacte. La figure 6 représente une telle courbe.

Le signal résultant de la différence est d'abord nul si la distance d est trop courte : l'impulsion de lumière R_IMP arrive trop tôt et se termine avant la fin de la durée Tᵢₙₜ ; les deux images intègrent la même quantité de lumière et leur différence est nulle. Puis le signal croît parce que la deuxième image continue à recevoir l'impulsion de lumière alors que la première image en reçoit de moins en moins au fur et à mesure que la distance d se rapproche de la valeur dᵢ ; puis le signal de différence atteint le maximum lorsque l'impulsion R_IMP coïncide avec l'intervalle de temps T'ᵢₙₜ - Tᵢₙₜ. Enfin, le signal de différence décroît lorsque la distance d dépasse dᵢ et il finit par devenir nul lorsque l'impulsion de retour R_IMP arrive après la fin de la durée T'ᵢₙₜ car alors aucune des deux intégrations ne correspond à la présence d'une impulsion de lumière réfléchie.

Par conséquent, on peut recueillir une image des points de la scène situés à une distance dᵢ et autour de cette distance à condition que la synchronisation entre le capteur et la source de lumière soit telle que l'impulsion de lumière réfléchie par un point à la distance dᵢ chevauche partiellement ou totalement la portion de durée T'ᵢₙₜ qui ne coïncide pas avec la durée Tᵢₙₜ.

Plus précisément, dans le cas de la figure 5, la synchronisation est telle que les durées Tᵢₙₜ et T'ᵢₙₜ commencent en même temps, la fin de l'impulsion de lumière R_IMP réfléchie par la scène observée, ne se situe pas plus tôt que la fin de la durée Tᵢₙₜ, et le début de l'impulsion de lumière réfléchie par la scène observée ne se situe pas plus tard que la fin de la durée T'ᵢₙₜ. Et de préférence, l'impulsion de lumière réfléchie se situe exactement au milieu entre ces deux positions extrêmes pour fournir un signal indiquant qu'il y a bien, pour le pixel considéré, un point de la scène à une distance dᵢ.

Mais on pourrait aussi envisager que les durées d'intégration Tᵢₙₜ et T'ᵢₙₜ commencent à des instants différents, T'ᵢₙₜ commençant avant Tᵢₙₜ, et se terminent au même instant. Dans ce cas, le retour de l'impulsion lumineuse issue d'une réflexion à une distance dᵢ doit chevaucher la partie de durée T'ᵢₙₜ qui commence avant le début de la durée Tᵢₙₜ.

Ces explications sont données en supposant que la durée Tᵢₘₚ des impulsions lumineuses est à peu près égale à la durée T'ᵢₙₜ - Tᵢₙₜ, ce qui est la situation la meilleure pour obtenir une précision élevée sur la détermination de la distance dᵢ (dans une application de mesure de distance) ou sur l'obtention d'une image correspondant le plus précisément possible à la distance dᵢ. En effet dans ce cas, l'impulsion réfléchie fournit un pic de signal lorsque le point de la scène est précisément à la distance dᵢ et on peut même détecter un écart par rapport à cette distance en observant la variation de niveau du signal, proportionnelle à l'écart de distance sur un écart correspondant à la moitié de la durée Tᵢₘₚ (c'est-à-dire sur une distance égale à cT_{imp/}2, c étant la vitesse de la lumière).

Il est possible cependant que la durée Tᵢₘₚ de l'impulsion lumineuse soit différente de la valeur T'ᵢₙₜ - Tᵢₙₜ ; dans ce cas, la précision qu'on peut en attendre est plus faible et est directement liée à la différence Tᵢₘₚ - (T'ᵢₙₜ-Tᵢₙₜ) ou (T'ᵢₙₜ-Tᵢₙₜ) - Tᵢₘₚ ; il y a, comme on l'a représenté à la figure 7 une courbe de variation du signal en fonction de la distance présentant un plateau dont la durée correspond à la valeur absolue de [Tᵢₘₚ -(T'ᵢₙₜ - Tᵢₙₜ)]. Sur ce plateau, le niveau de signal ne change pas malgré la variation de distance autour de dᵢ.

On a encore représenté sur la figure 8 un chronogramme de fonctionnement selon l'invention dans le cas où on fait la différence entre deux images complètes obtenues pendant deux trames successives, avec deux impulsions de lumière, correspondant chacune à une trame respective. Les impulsions de lumière doivent être identiques en durée et en intensité pour que la différence entre les images soit significative. La synchronisation entre les impulsions de lumière et les durées d'intégration du capteur répondent aux mêmes principes que dans le cas de la figure 5, mais bien entendu la coïncidence entre l'impulsion de retour R_IMP et la portion de durée d'intégration T'ᵢₙₜ qui ne coïncide pas avec la durée Tᵢₙₜ se comprend bien entendu en décalant la durée Tᵢₙₜ d'une valeur égale à la durée de trame Tᵣ.

On notera que dans ce qui précède on a considéré qu'il y avait une impulsion de lumière unique donnant lieu à une intégration. Cependant, on peut améliorer le rapport signal/bruit en multipliant le nombre d'impulsions avant de lire le résultat de l'intégration des charges générées par les différentes impulsions. On produit alors, pour une même durée tᵢ, un train d'impulsions. Cela suppose que les durées tᵢ qui définissent la fin du temps d'intégration soient bien identiques pour les différentes impulsions du train d'impulsion. Les charges générées par la lumière sont accumulées dans les photodiodes après chaque impulsion, et il y a un signal de transfert TR (figure 2) vers le noeud de stockage après chaque impulsion, mais la lecture des noeuds de stockage par les signaux SHRᵢ SHSᵢ n'a lieu qu'après la dernière impulsion d'un train d'impulsions quand la totalité des charges résultant des impulsions du train sont arrivées.

## Revendications

1. Procédé pour réaliser une prise de vue d'une scène avec un temps d'intégration très court, en utilisant un capteur d'image comportant une matrice de pixels, chaque pixel comportant une photodiode (PH) et des moyens de lecture des charges accumulées par la photodiode pendant une durée d'intégration, la matrice comportant en outre des moyens de séquencement pour établir des instants de début et de fin de la durée d'intégration, le procédé étant **caractérisé en ce que** l'on produit deux images d'une même scène dans des conditions de lumière identiques, l'une des images correspondant à une intégration de charges pendant un premier intervalle de temps de durée Tᵢₙₜ et correspondant aux lignes paires de la matrice, l'autre image correspondant à un deuxième intervalle de temps de durée T'ᵢₙₜ plus grande que Tᵢₙₜ et correspondant aux lignes impaires de la matrice, et on établit une différence entre ces deux images, représentant une image intégrée pendant le temps d'intégration très court T'ᵢₙₜ - Tᵢₙₜ, la différence étant constituée par la différence pixel à pixel entre les luminances, correspondant aux charges accumulées par la photodiode, des pixels d'une ligne impaire et les luminances des pixels d'une ligne paire immédiatement adjacente.

2. Procédé selon la revendication 1, **caractérisé en ce qu'**on utilise pour éclairer la scène une source de lumière commandée fournissant des impulsions de lumière (IMP) calibrées en durée et en intervalles en synchronisme avec le fonctionnement du capteur, et on produit les deux images de la scène, éclairée par une impulsion de lumière.

3. Procédé selon la revendication 2, **caractérisé en ce que** la scène observée est située à une distance déterminée dᵢ, et la synchronisation entre la source de lumière et le capteur est telle que la fin de l'impulsion de lumière (R_IMP) réfléchie par la scène observée et correspondant à l'image intégrée pendant la durée Tᵢₙₜ, chevauche totalement ou partiellement la portion de durée T'ᵢₙₜ qui ne coïncide pas avec la durée Tᵢₙₜ.

4. Procédé selon l'une des revendications 1 à 3, **caractérisé en ce que** les images sont produites à partir d'un train d'impulsions de lumière.

5. Procédé selon l'une des revendications précédentes, **caractérisé en ce que** le premier intervalle de temps de durée Tᵢₙₜ et le deuxième intervalle de temps de durée T'ᵢₙₜ sont établis à partir de circuits logiques asynchrones comprenant des inverseurs CMOS.

## Patentansprüche

1. Verfahren zur Bildaufnahme einer Szene mit einer sehr kurzen Integrationszeit unter Verwendung eines Bildsensors, welcher eine Pixelmatrix beinhaltet, wobei jeder Pixel eine Photodiode (PH) und Lesemittel der durch die Photodiode über eine Integrationsdauer angesammelten Ladungen beinhaltet, wobei die Matrix zudem Sequenzierungsmittel beinhaltet, um Anfangs- und Endzeitpunkte der Integrationsdauer zu ermitteln, wobei das Verfahren **dadurch gekennzeichnet ist, dass** zwei Bilder einer gleichen Szene unter identischen Lichtbedingungen erzeugt werden, wobei eines der Bilder einer Integration der Ladungen innerhalb eines ersten Zeitintervalls Tᵢₙₜ entspricht und den geradzahligen Zeilen der Matrix entspricht, und das andere Bild einem zweiten Zeitintervall T'ᵢₙₜ entspricht, welcher größer ist als Tᵢₙₜ, und den ungeradzahligen Zeilen der Matrix entspricht, und eine Differenz zwischen diesen beiden Bildern ermittelt wird, welche ein während der sehr kurzen Integrationszeit T'ᵢₙₜ - Tᵢₙₜ integriertes Bild darstellt, wobei die Differenz durch die Differenz, Pixel für Pixel, zwischen den Helligkeiten, entsprechend den durch die Photodiode angesammelten Ladungen, der Pixel einer ungeradzahligen Zeile und den Helligkeiten der Pixel einer unmittelbar angrenzenden geradzahligen Zeile gebildet wird.

2. Verfahren nach Anspruch 1, **dadurch gekennzeichnet, dass** zum Beleuchten der Szene eine gesteuerte Lichtquelle verwendet wird, welche zeitlich und in mit der Funktionsweise des Sensors synchronisierten Intervallen kalibrierte Lichtimpulse (IMP) bereitstellt, und die beiden Bilder der durch einen Lichtimpuls beleuchteten Szene erzeugt werden.

3. Verfahren nach Anspruch 2, **dadurch gekennzeichnet, dass** die beobachtete Szene in einem bestimmten Abstand dᵢ befindlich ist, und die Synchronisierung zwischen der Lichtquelle und dem Sensor so geartet ist, dass das Ende des Lichtimpulses (R_IMP), welcher von der beobachteten Szene reflektiert wird und dem über die Dauer Tᵢₙₜ integrierten Bild entspricht, vollständig oder teilweise den Abschnitt der Dauer T'ᵢₙₜ überlappt, welcher nicht mit der Dauer Tᵢₙₜ übereinstimmt.

4. Verfahren nach einem der Ansprüche 1 bis 3, **dadurch gekennzeichnet, dass** die Bilder anhand einer Lichtimpulsfolge erzeugt werden.

5. Verfahren nach einem der vorhergehenden Ansprüche, **dadurch gekennzeichnet, dass** der erste Zeitintervall mit Dauer Tᵢₙₜ und der zweite Zeitintervall mit Dauer T'ᵢₙₜ anhand asynchroner logischer Schaltkreise ermittelt werden, welche CMOS-Inverter beinhalten.

## Claims

1. A method for imaging a scene with a very short integration time by using an image sensor comprising a matrix of pixels, each pixel comprising a photodiode (PH) and means for reading the charges accumulated by the photodiode during an integration duration, the matrix furthermore comprising sequencing means for establishing start and end instants of the integration duration, the method being **characterized in that** two images of the same scene are produced under identical light conditions, one of the images corresponding to integration of charges during a first time interval with a duration Tᵢₙₜ and corresponding to the even rows of the matrix, the other image corresponding to a second time interval with a duration T'ᵢₙₜ longer than Tᵢₙₜ and corresponding to the odd rows of the matrix, and a difference between these two images is established, representing an image integrated during the very short integration time T'ᵢₙₜ - Tᵢₙₜ, the difference being formed by the pixel-to-pixel difference between the luminances, corresponding to the charges accumulated by the photodiode, of the pixels of an odd row and the luminances of the pixels of an even row immediately adjacent.

2. The method as claimed in claim 1, **characterized in that** a controlled light source providing light pulses (IMP) calibrated in duration and in intervals in synchronism with the operation of the sensor is used to illuminate the scene, and two images of the scene, illuminated by a light pulse, are produced.

3. The method as claimed in claim 2, **characterized in that** the observed scene lies at a determined distance dᵢ, and the synchronization between the light source and the sensor is such that the end of the light pulse (R_IMP) reflected by the observed scene and corresponding to the image integrated during the duration Tᵢₙₜ fully or partially overlaps the portion of duration T'ᵢₙₜ that does not coincide with the duration Tᵢₙₜ.

4. The method as claimed in one of claims 1 to 3, **characterized in that** the images are produced on the basis of a train of light pulses.

5. The method as claimed in one of the preceding claims, **characterized in that** the first time interval with a duration Tᵢₙₜ and the second time interval with a duration T'ᵢₙₜ are established on the basis of asynchronous logic circuits comprising CMOS inverters.
